Europäisches Patentamt

European Patent Office

Office européen des brevets

(19)

(11) **EP 1 073 909 B1**

(12) **EUROPÄISCHE PATENTSCHRIFT**

(45) Veröffentlichungstag und Bekanntmachung des Hinweises auf die Patenterteilung:
**25.08.2004 Patentblatt 2004/35**

(21) Anmeldenummer: **99924686.1**

(22) Anmeldetag: **25.03.1999**

(51) Int Cl.⁷: $G01R\ 19/00$, $G01R\ 15/24$

(86) Internationale Anmeldenummer:
**PCT/DE1999/000911**

(87) Internationale Veröffentlichungsnummer:
**WO 1999/050678 (07.10.1999 Gazette 1999/40)**

(54) **VERFAHREN UND ANORDNUNG ZUR VERARBEITUNG MINDESTENS EINES ANALOGEN, MEHRERE FREQUENZBEREICHE UMFASSENDEN SIGNALS**

METHOD AND CONFIGURATION FOR PROCESSING AT LEAST ONE ANALOG SIGNAL COMPRISING SEVERAL FREQUENCY RANGES

PROCEDE ET DISPOSITIF DESTINES AU TRAITEMENT D'AU MOINS UN SIGNAL ANALOGIQUE COMPORTANT PLUSIEURS PLAGES DE FREQUENCES

(84) Benannte Vertragsstaaten:
**CH DE FR GB LI**

(30) Priorität: **31.03.1998 DE 19814372**
**10.07.1998 DE 19830987**

(43) Veröffentlichungstag der Anmeldung:
**07.02.2001 Patentblatt 2001/06**

(73) Patentinhaber: **SIEMENS AKTIENGESELLSCHAFT**
**80333 München (DE)**

(72) Erfinder:
• **MOHR, Stephan**
**D-07747 Jena (DE)**
• **WILLSCH, Michael**
**D-90762 Fürth (DE)**
• **BOSSELMANN, Thomas**
**D-91054 Erlangen (DE)**
• **WOLLENHAUPT, Mario**
**D-99718 Westgreusen (DE)**
• **MENKE, Peter**
**D-91362 Pretzfeld (DE)**

(56) Entgegenhaltungen:
EP-A- 0 444 233          WO-A-91/12533
DE-A- 19 608 944         DE-C- 19 601 727
US-A- 5 347 464          US-A- 5 546 081
US-A- 5 646 569

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 073 909 B1

**Beschreibung**

Die Erfindung betrifft ein Verfahren und eine Anordnung zur Verarbeitung mindestens eines analogen, mehrere Frequenzbereiche umfassenden Signals.

Insbesondere bezieht sich die Erfindung auf ein Verfahren und eine Anordnung zur Verarbeitung von Ausgangsgrößen eines optischen Wandlers.

Es ist ein optischer Wandler zum Erfassen einer elektrischen Meßgröße bekannt. Dies gilt insbesondere für die optische Messung eines elektrischen Stroms unter Ausnutzung des Faraday-Effekts und auch für die optische Messung einer elektrischen Spannung unter Ausnutzung des Pockels-Effekts. In ein unter dem Einfluß der zu messenden elektrischen Meßgröße stehendes Sensorelement (zum Beispiel Faraday-Element oder Pockels-Element) wird ein polarisiertes Lichtsignal eingekoppelt, dessen Polarisation sich unter dem Einfluß der elektrischen Meßgröße verändert. Die Polarisationsänderung ist damit ein Maß für die Meßgröße. Weiterhin ist eine Ausführungsform bekannt, bei der zwei polarisierte Lichtsignale mit gegenläufiger Laufrichtung in das Sensorelement eingekoppelt werden. Zur Analyse der Polarisationsänderung wird jedes Lichtsignal nach wenigstens einmaligem Durchlaufen des Sensorelements einem (Polarisations-) Analysator zugeführt. Dieser kann das zugehörige Lichtsignal entweder in zwei linear polarisierte Lichtteilsignale mit unterschiedlichen, im allgemein senkrecht zueinander gerichteten Polarisationsebenen aufteilen (zweikanalige Auswertung) oder nur einen auf eine vorgegebene Polarisationsrichtung projizierten Lichtanteil durchlassen (einkanalige Auswertung). Aus den Lichtintensitäten der beiden Lichtteilsignale oder des Lichtanteils werden beispielsweise mit Hilfe von Photodioden korrespondierende elektrische Signale erzeugt, aus denen ein Polarisationssignal abgeleitet wird. Dieses Polarisationssignal ist ein Maß für die Änderung der Polarisation des Lichtsignals in dem Sensorelement unter dem Einfluß der zu messenden elektrischen Wechselgröße.

Mit der *WO 95/10046 A1* sowie mit der *DE 196 01* 727 *C1* wird am Beispiel eines magnetooptischen Stromwandlers offenbart, wie das beschriebene Polarisationssignal aus zwei Lichtteilsignalen LT1 und LT2 bzw. aus den daraus ermittelten elektrischen (Intensitäts-)Signalen I1 und I2 zu berechnen ist. Das Polarisationssignal P wird als Quotient aus einer Differenz und der Summe der beiden elektrischen Signale I1 und I2 entsprechend:

$$P = \frac{(I1 - I2)}{(I1 + I2)} \tag{1}$$

gebildet. Bei Vernachlässigung von Störeinflüssen ist dieses Polarisationssignal P gleich:

$$P = \sin(2\rho) = \sin(2 \cdot N \cdot V \cdot I), \tag{2}$$

wobei $\rho$ den sog. Faraday-Drehwinkel bezeichnet. Der Faraday-Drehwinkel $\rho$ entspricht hierbei dem Winkel, um den die Polarisation des Lichtsignals aufgrund des zu detektierenden elektrischen Stroms I in dem Faraday-Element gedreht wird. Er ist gemäß der Beziehung:

$$\rho = 2 \cdot N \cdot V \cdot I \tag{3}$$

im wesentlichen direkt proportional zur Amplitude des zu messenden Stroms I. Außerdem steht in Gleichung (3) N für die Zahl der Umläufe des Lichtsignals um einen vom zu messenden Strom I durchflossenen Stromleiter und V für die sogenannte Verdet-Konstante V. Bei der Verdet-Konstante V handelt es sich um eine im allgemeinen vom Material und der Temperatur abhängige Kenngröße des Faraday-Elements.

Ein begrenzender Faktor des beschriebenen optischen Wandlers liegt in der Periodizität der meßgrößenabhängigen Polarisation. Bei dem Faraday-Effekt beispielsweise wiederholt sich der Polarisationszustand nach einer 180°-Rotation der linearen Eingangspolarisation. Daraus ergibt sich zunächst ein begrenzter eindeutiger Meßbereich für die zu detektierende elektrische Wechselgröße.

Reduziert man die Empfindlichkeit des Sensors, um möglichst große Signalamplituden der elektrischen Wechselgröße noch in dem begrenzten Meßbereich abbilden zu können, so geht dies zu Lasten kleiner Signalamplituden, die sich dann nicht mehr aus dem Rauschen extrahieren lassen. Umgekehrt wirkt sich eine Erhöhung der Empfindlichkeit zur besseren Erfassung kleiner Signalamplituden negativ auf die im begrenzten Meßbereich abbildbare maximale Signalamplitude aus.

Im Bereich der öffentlichen elektrischen Energieversorgung, einem unter anderem aufgrund der inhärent gegebenen hohen elektromagnetischen Verträglichkeit potentiellen Einsatzfeld optischer Meßverfahren, muß ein hoher Dynamikbereich der zu detektierenden elektrischen Wechselgröße, insbesondere des elektrischen Stroms, abgedeckt werden können. Die Forderung nach höchster Meßgenauigkeit bei kleiner Stromamplitude ist eine Vorgabe aus der Verrechnungszählung. Auf der anderen Seite muß im Rahmen der Kurzschluß-Stromerkennung auch eine sehr hohe Stromamplitude sicher erkannt werden können.

Um den genannten Forderungen gerecht zu werden, ist ein Verfahren entwickelt worden, das einen vor allem nach oben erweiterten Meßbereich hat. Mit der *EP 0 613 015 A1* ist ein elektrooptischer Spannungswandler offenbart, dessen Meßbereich sich über den eindeutigen Bereich der ersten Periode hinaus erstreckt. Dabei werden zwei optische Lichtsignale ausgewertet, die mit vorgegebener versetzter Phase durch ein Pockels-Element gesendet werden. Eine Signalrekonstruktion für die zu messende elektrische Spannung erfolgt über ein spezielles Zählverfahren, das die Nulldurchgänge von aus den beiden Lichtsignalen abgeleiteten Polarisationssignalen auswertet. Der Meßbereich dieses elektrooptischen Spannungswandlers ist folglich prinzipiell nicht mehr nach oben begrenzt.

Weiterhin ist aus der *EP 0 208 593 B1* ein magnetooptischer Stromwandler bekannt, der zwei elektrische Signale generiert, die jeweils mehrdeutige Funktionen des zu messenden Stroms sind und die um einen Winkel von 90° gegeneinander phasenverschoben sind. Durch Vergleich der Vorzeichen und der Beträge wird aus diesen beiden mehrdeutigen Signalen ein eindeutiges Meßsignal zusammengesetzt. Auch der Meßbereich dieses magnetooptischen Stromwandlers ist somit prinzipiell nicht mehr nach oben begrenzt.

Mit der DE 196 01 727 C1 wird ein magnetooptischer Stromwandler mit erweitertem Meßbereich offenbart, der ein Polarisationssignal liefert, das ähnlich zur Funktion tan($\rho$) des Faraday-Drehwinkels $\rho$ ist. Das in der Auswerteinheit berechnete Polarisationssignal wird hier nur innerhalb des Eindeutigkeitsbereichs der tan($\rho$)-Funktion ausgewertet. Verglichen mit der üblichen Ausführungsform, die gemäß vorstehender Gleichung (2) nur ein zu sin(2p) proportionales Polarisationssignal liefert, erhält man einen praktisch doppelt so großen Meßbereich.

Nach Durchlaufen des Sensorelements werden aus den Lichtteilsignalen über photoelektrische Wandlereinheiten elektrische Signale erzeugt. Bei der Ableitung des Polarisationssignals aus diesen elektrischen Signalen bedienen sich die mit der DE 196 01 727 C1 und mit der WO 95/10046 A1 offenbarten Anordnungen zunächst der analogen Schaltungstechnik. Es werden jedoch auch Hinweise gegeben, daß die Auswertung entsprechend digital durchgeführt werden kann. Auch mit dem Aufsatz *"Vergleichende Darstellung verschiedener magnetooptischer Stromwandlerkonzepte" von T. Bosselmann, 113. PTB-Seminar Unkonventionelle Meßwandler für Hochspannungsnetze*", *Braunschweig, 15.-16.11.1993* wird eine digitale Auswertung eines optischen Stromwandlers offenbart. Dabei werden die elektrischen Signale am Ausgang der photoelektrischen Wandlereinheiten zunächst über Analog-Digital(A/D) -Wandler digitalisiert, um dann in einer digitalen Berechnungseinheit, die beispielsweise einen digitalen Signalprozessor beinhalten kann, weiterverarbeitet zu werden. Diese digitale Form der Signalverarbeitung ist besonders dann sehr nützlich, wenn Störgrößen wie etwa Temperatureinflüsse eliminiert werden sollen, oder die gemäß Gleichung (2) sinusförmige Kennlinie linearisiert werden soll. Optische Wandler bedienen sich genau aus diesem Grund heute überwiegend einer digitalen Auswertung.

Durch die Quantisierung der elektrischen Signale in den A/D-Wandlern wird zwangsläufig ein zusätzlicher Rauschanteil, das sogenannte Quantisierungsrauschen, erzeugt. Dieser zusätzliche Rauschanteil ist besonders dann störend, wenn sehr kleine Signalamplituden der zu messenden elektrischen Wechselgröße und damit verbunden auch sehr kleine Polarisationsänderungen detektiert werden sollen. Dieses Quantisierungsrauschen begrenzt somit den auswertbaren Dynamikbereich des optischen Wandlers.

In der *DE 196 08* 944 *A1* wird ein Verfahren und eine Anordnung zur magnetooptischen Stromwandlung beschrieben. Die elektrische Ausgangsgröße des optischen Stromwandlers wird in ein die Meßinformation tragendes hochfrequentes Teilsignal und in ein niederfrequentes Teilsignal zerlegt. Das hochfrequente Teilsignal wird digitalisiert, wobei das niederfrequente Teilsignal als Referenzsignal des A/D-Wandlers verwendet wird. Auf diese Weise kann eine Störung auf der optischen Übertragungsstrecke unmittelbar kompensiert werden. Eine Erhöhung des Dynamikbereichs wird mit dem offenbarten Verfahren allerdings nicht erreicht.

Weiterhin ist aus der *US 5,347,464* ein nicht-optisches Verfahren und eine nicht-optische Anordnung zur Oberwellenbestimmung im Netz der öffentlichen elektrischen Energieversorgung bekannt. Aus einer Ausgangsgröße eines elektrischen Meßwandlers werden mittels Frequenzfilterung zwei Teilsignale erzeugt, die einem A/D-Wandler zugeführt werden. Vor der Digitalisierung wird eines der beiden Teilsignale noch analog verstärkt. Dabei kann der analoge Verstärkungsfaktor an den Aussteuerungsbereich des nachgeschalteten A/D-Wandlers angepaßt werden.

Die Aufgabe der Erfindung besteht nun in der Angabe eines Verfahrens und einer Anordnung der einleitend jeweils bezeichneten Art mit einem im Vergleich zum Stand der Technik reduzierten Quantisierungsrauschen und erweiterten Dynamikbereich. Insbesondere soll auch eine Verbesserung des S/N(Signal to Noise)-Verhältnisses erreicht werden.

Zur Lösung dieser Aufgabe werden ein Verfahren und eine Anordnung entsprechend den Merkmalen des jeweiligen unabhängigen Patentanspruchs 1 bzw. 12 angegeben.

Bei dem erfindungsgemäßen Verfahren zur Verarbeitung mindestens eines analogen, mehrere Frequenzbereiche umfassenden Signals handelt es sich um ein Verfahren, bei welchem

a) das mindestens eine analoge Signal als mindestens ein Folgesignal aus einem ersten und zweiten elektrischen Signal eines optischen Wandlers für eine elektrische Wechselgröße abgeleitet wird,

b) von jedem Folgesignal eine Aufteilung in einen Gleichanteil und einen Restanteil mit voneinander verschiedenem Frequenzbereich vorgenommen wird,

c) mittels analoger Verstärkung um einen analogen Verstärkungsfaktor aus dem Restanteil ein verstärkter Restanteil erzeugt wird,

d) aus den elektrischen Signalen und dem verstärkten Restanteil digitale elektrische Signale und ein digitaler verstärkter Restanteil erzeugt werden, wobei der analoge Verstärkungsfaktor an einen Aussteuerungsbereich bei der Digitalisierung angepaßt wird, und

e) aus den genannten digitalen Größen sowie aus einem dem Gleichanteil entsprechenden digitalen Gleichanteil und aus einem dem analogen Verstärkungsfaktor entsprechenden digitalen Verstärkungsfaktor ein von der zu messenden Wechselgröße abhängiges digitales Polarisationssignal ermittelt wird.

Bei der erfindungsgemäßen Anordnung zur Verarbeitung mindestens eines analogen, mehrere Frequenzbereiche umfassenden Signals handelt es sich um eine Anordnung, welche umfaßt

a) Mittel zur Aufteilung mindestens eines aus zwei elektrischen Signalen eines optischen Wandlers für eine elektrische Wechselgröße abgeleiteten Folgesignals in einen Gleichanteil und einen Restanteil mit voneinander verschiedenem Frequenzbereich, wobei das mindestens eine Folgesignal dem mindestens einen analogen Signal entspricht,

b) einen analogen Verstärker mit einem analogen Verstärkungsfaktor zur Erzeugung eines verstärkten Restanteils aus dem Restanteil,

c) Digitalisierungsmittel zur Erzeugung von digitalen elektrischen Signalen und eines digitalen verstärkten Restanteils jeweils aus den elektrischen Signalen und dem verstärkten Restanteil, wobei der analoge Verstärkungsfaktor an einen Aussteuerungsbereich der Digitalisierungsmittel angepaßt ist, und

d) eine digitale Berechnungseinheit zur Ermittlung eines von der zu messenden Wechselgröße abhängigen digitalen Polarisationssignals aus den genannten digitalen Größen sowie aus einem dem Gleichanteil entsprechenden digitalen Gleichanteil und aus einem dem analogen Verstärkungsfaktor entsprechenden digitalen Verstärkungsfaktor.

Die Erfindung beruht dabei auf der Erkenntnis, daß sich das Quantisierungsrauschen der Digitalisierungsmittel zur Erzeugung digitaler Signale, insbesondere das eines A/D-Wandlers, einem Nutzsignal additiv überlagert. Das besagte Quantisierungsrauschen ist nur abhängig vom gewählten A/D-Wandler, nicht jedoch von dem zu digitalisierenden Signal. Das Quantisierungsrauschen begrenzt somit als Grundrauschen die Detektierbarkeit von kleinen Signalamplituden. Somit begrenzt das Quantisierungsrauschen auch den Dynamikbereich insgesamt.

Häufig setzt sich ein analoges Signal, wie auch das aus Ausgangsgrößen eines optischen Wandlers abgeleitete Folgesignal, aus mehreren Frequenzbereichen zusammen, in denen unterschiedliche Signalpegel vorliegen. Eine entsprechend dieser Frequenzbereiche vorgenommene Aufteilung des analogen Signals in die Teilsignale bietet die Möglichkeit, jedes Teilsignal entsprechend seines Teilsignalpegels zu verstärken und somit an den Aussteuerbereich des nachfolgenden A/D-Wandlers anzupassen. Dadurch werden die Nutzsignalanteile in den Teilsignalen jeweils verstärkt, wohingegen das nur von den A/D-Wandlern abhängige Quantisierungsrauschen konstant bleibt. Somit sinkt der relative Rauschbeitrag des Quantisierungsrauschens, und es resultiert ein verbessertes Gesamt-S/N-Verhältnis. Das Folgesignal des optischen Wandlers wird bei dieser Frequenzaufteilung in zwei Teilsignale, den Gleichanteil und den Restanteil, deren Frequenzbereiche verschieden voneinander sind, zerlegt.

Nicht immer sind alle Teilsignale zu verstärken. Dies ist insbesondere dann nicht notwendig, wenn die entsprechenden Teilsignalpegel die nachfolgenden A/D-Wandler bereits in hohem Maße aussteuern. Eine zusätzliche Verstärkung bringt dann praktisch keine weiteren Vorteile mehr. Es ist andererseits auch möglich, daß zumindest eines der Teilsignale nicht verstärkt, sondern gedämpft wird. Dies kann beispielsweise für ein Teilsignal mit einem niedrigen Informationsgehalt, aber dennoch sehr hohem Teilsignalpegel vorgesehen werden. Der analoge Verstärkungsfaktor kann somit Werte größer, gleich oder kleiner eins annehmen.

Der optische Wandler ist zur Detektion einer elektrischen Meßgröße, beispielsweise einer elektrischen Spannung oder eines elektrischen Stroms, ausgelegt. Das analoge Signal entspricht dann einem Folgesignal, das aus den Ausgangsgrößen des optischen Wandlers abgeleitet wird. Unter der Ausgangsgröße des optischen Wandlers wird in diesem Zusammenhang ein elektrisches Signal einer photoelektrischen Wandlung verstanden. Das Folgesignal wird aus mindestens einem dieser elektrischen Signale gebildet.

Ein Frequenzspektrum der zu detektierenden elektrischen Meßgröße reicht dabei im allgemeinen von 0 Hz bis zu einigen 10 kHz. Im Zusammenhang mit der öffentlichen elektrischen Energieversorgung kommt eine Meßgröße mit relevantem Gleichanteil insbesondere bei der Hochspanungs-Gleichstrom-Übertragung vor. Ansonsten liegt der dominante Frequenzanteil bei der üblichen 50Hz- oder 60Hz-Netzfrequenz. Anteile in der Meßgröße bei höheren Frequenzen rühren von Oberwellen der Netzfrequenz oder von Transienten her. Diese Frequenzanteile der Meßgröße weisen normalerweise sehr unterschiedliche Signalpegel auf. Da sich diese unterschiedliche Signalpegel auch in dem Folgesignal wiederfinden, läßt sich dieses vorteilhaft entsprechend der beschriebenen Vorgehensweise aufteilen und weiterverarbeiten.

Der optische Wandler ist zur Detektion einer elektrischen Wechselgröße bestimmt. Unter einer elektrischen Wechselgröße wird in diesem Zusammenhang verstanden, daß das zugehörige Spektrum nur von null verschiedene Frequenzanteile aufweist. Mindestens ein aus zwei elektrischen Signalen gebildetes Folgesignal wird in einen Gleichanteil und einen Restanteil aufgeteilt, wovon nur der Restanteil um einen Verstärkungsfaktor analog verstärkt wird. Die beiden elektrischen Signale sowie der verstärkte Restanteil werden digitalisiert und zur digitalen Ermittlung eines Polarisationssignals, das von der zu messenden Wechselgröße abhängt, herangezogen. Als weitere Eingangsgrößen dienen ein digitaler Gleichanteil sowie ein digitaler Verstärkungsfaktor, die ihrem jeweiligen analogen Gegenpart entsprechen.

Insbesondere bei kleinen Signalamplituden der zu messenden Wechselgröße setzen sich die elektrischen Signale jeweils aus dem größeren Gleichanteil, entsprechend einem (Gleich-)Lichtsignal, das durch ein Sensorelement des optischen Wandlers gesendet wird, sowie aus einem kleineren zweiten Teil, der hier als Restanteil bezeichnet wird und der die Information über die zu messende elektrische Wechselgröße trägt, zusammen. Dieser Restanteil enthält somit das Nutzsignal des optischen Wandlers.

Durch eine Abtrennung des hier keine Information tragenden Gleichanteils vor der Digitalisierung gewinnt man den Spielraum für eine vorgeschaltete analoge Verstärkung des verbleibenden Restanteils (Nutzsignal). Die Verstärkung des Restanteils kann dann an die Gegebenheiten, d.h. den Aussteuerbereich, des A/D-Wandlers angepaßt werden. Da insbesondere bei kleinen Signalamplituden der Gleichanteil wesentlich größer als der Restanteil ist, würde eine Verstärkung des elektrischen Signals in seiner ursprünglichen Form sehr schnell zu einer Übersteuerung des A/D-Wandlers führen.

Berücksichtigt man bei der Berechnung des digitalen Polarisationssignals den in seinem S/N-Verhältnis verbesserten digitalen verstärkten Restanteil, dann ergibt sich auch ein insgesamt verbessertes S/N-Verhältnis. Der Gewinn im S/N-Verhältnis beträgt im Vergleich zur Digitalisierung ohne vorgeschaltete Verstärkung bis zu 6 dB multipliziert mit dem Logarithmus Dualis des verwendeten analogen Verstärkungsfaktors. Folglich resultiert auch die gewünschte Erweiterung des Dynamikbereichs.

Da gleichzeitig neben dem verstärkten Restanteil auch die ursprünglichen elektrischen Signale digitalisiert und der digitalen Berechnungseinheit zugeführt werden, bleiben insbesondere die Möglichkeiten zur Erfassung großer Signalamplituden in vollem Umfang gemäß dem Stand der Technik bestehen.

Besondere Ausgestaltungen und Weiterbildungen des Verfahrens und der Anordnung nach der Erfindung ergeben sich aus den jeweils abhängigen Unteransprüchen.

Insgesamt drei bevorzugte Ausgestaltungen des Verfahrens betreffen dabei die Aufteilung des aus den elektrischen Signalen gebildeten Folgesignals.

In einer ersten Ausgestaltung wird das Folgesignal sowohl einer Tiefpaß- als auch einer Hochpaßfilterung unterzogen. Die Tiefpaßfilterung liefert dabei den Gleichanteil, die Hochpaßfilterung den Restanteil. Vorteilhaft ist die Hochpaßfilterung dabei komplementär zur Tiefpaßfilterung ausgebildet, so daß die Summe von Gleichanteil und Restanteil exakt das Folgesignal ergibt. Durch die beiden Filterungen gehen somit keine Frequenzanteile des Folgesignals verloren.

In einer zweiten vorteilhaften Ausgestaltung des Verfahrens wird der Gleichanteil ebenfalls durch eine Tiefpaßfilterung ermittelt. Der Restanteil wird nun jedoch nicht über eine Hochpaßfilterung, sondern durch eine Differenzbildung aus Folgesignal und Gleichanteil ermittelt. Im Vergleich zur vorher genannten Ausgestaltung wird somit die Hochpaßfilterung eingespart.

Eine dritte vorteilhafte Ausgestaltung zur Aufteilung des Folgesignals kommt ohne eine explizite Filterung aus. Statt dessen wird der Gleichanteil durch einen vorzugebenden Offset-Wert nachgebildet. Der Restanteil wird analog zur oben beschriebenen zweiten Ausgestaltung durch eine Differenzbildung aus dem Folgesignal und dem Gleichanteil ermittelt.

Diese Vorgehensweise ist möglich, da eine Lichtintensität des in das Sensorelement eingestrahlten Lichtsignals bekannt ist und sogar über eine Lichtquelle eingestellt werden kann. Folglich ist auch der durch diese Lichtintensität maßgeblich bestimmte Gleichanteil im Folgesignal seinem Wert nach zumindest ungefähr bekannt. Wird der vorzugebende Offset-Wert nun entsprechend dieses bekannten Wertes eingestellt, so erhält man eine sehr gute Nachbildung des tatsächlichen Gleichanteils. Die Abweichung vom tatsächlichen Gleichanteil bei dieser Methode kann sich innerhalb tolerierbarer Grenzen, die durch einen positiven und einen negativen Quotienten aus dem Gleichanteil und dem analogen Verstärkungsfaktor $[\pm(\text{Gleichanteil/analoger Verstärkungsfaktor})]$ gegeben sind, bewegen, ohne daß es zu einer maßgeblichen Verschlechterung der Resultate kommt.

Durch eine vom tatsächlichen Gleichanteil unter Umständen leicht abweichende Vorgabe des Offset-Wertes ergibt sich nach der Differenzbildung mit dem Folgesignal ein Restanteil, der noch in geringem Umfang mit einem Gleichanteil behaftet ist. Liegen die Abweichungen jedoch innerhalb der genannten tolerierbaren Fehlergrenzen, kann die für die Verbesserung des S/N-Verhältnisses entscheidende Verstärkung des Restanteils immer noch mit Vorteil vor der nachgeschalteten Digitalisierung durchgeführt werden.

Drei weitere bevorzugte Ausführungsformen des Verfahrens haben die Bildung des mindestens einen Folgesignals und die davon abhängige Bestimmung des digitalen Polarisationssignals zum Gegenstand.

In einer diesbezüglich ersten bevorzugten Ausführungsform wird nur ein einziges Folgesignal abgeleitet. Hierbei entspricht dieses eine Folgesignal einem der beiden elektrischen Signale. Das Folgesignal wird entsprechend den oben beschriebenen Ausgestaltungen in Gleichanteil und Restanteil aufgeteilt, und der Restanteil wird verstärkt. Anschließend erfolgt eine Digitalisierung der beiden elektrischen Signale, des verstärkten Restanteils sowie je nach verwendeter Ausgestaltung der Aufteilung auch des Gleichanteils. Das digitale Polarisationssignal wird dann aus diesen digitalen Signalen sowie dem digitalen Verstärkungsfaktor ermittelt.

Der digitale Verstärkungsfaktor kann dabei als fester digitaler Wert, der dem fest eingestellten analogen Verstärkungsfaktor entspricht, vorliegen. Alternativ dazu ist es möglich, den digitalen Verstärkungsfaktor gemäß der momentanen Signalamplitude zu wählen und den analogen Verstärkungsfaktor entsprechend dieses gewählten digitalen Verstärkungsfaktors einzustellen.

In einer zweiten bevorzugten Ausführungsform kommen zwei Folgesignale zum Einsatz, wobei jedes der beiden elektrischen Signale einem Folgesignal entspricht und wie oben beschrieben aufgeteilt, verstärkt und digitalisiert wird. Das digitale Polarisationssignal wird mit Hilfe der digitalen verstärkten Restanteile, der digitalen Gleichanteile, der elektrischen Signale sowie der digitalen Verstärkungsfaktoren bestimmt.

In der dritten vorteilhaften Ausführungsform wird ein Folgesignal aus den beiden elektrischen Signalen durch Bildung eines Differenzsignals erzeugt.

Unter der Annahme idealer Bedingungen würde eine Differenz aus den beiden elektrischen Signalen von vornherein nur einen meßgrößenabhängigen Anteil, also den Restanteil, beinhalten. Durch die in der Realität vorkommenden Störgrößen, wie Temperatureinflüsse oder Unsymmetrien, wird das Differenzsignal im allgemeinen dennoch einen Gleichanteil aufweisen, der mit den oben beschriebenen Verfahrensschritten abgespalten werden kann.

Eine Verstärkung erfolgt nur für den die Meßinformation tragenden Restanteil. Das digitale Polarisationssignal wird anhand der digitalen elektrischen Signale, dem digitalen verstärkten Restanteil des Differenzsignals, dem digitalen Gleichanteil des Differenzsignals sowie dem digitalen Verstärkungsfaktor ermittelt.

Insgesamt drei bevorzugte Ausgestaltungen der Anordnung betreffen die Mittel zur Aufteilung des aus den elektrischen Signalen gebildeten Folgesignals. Das im Zusammenhang mit den entsprechenden Ausgestaltungen des Verfahrens gesagte, insbesondere hinsichtlich der Vorteile, gilt analog auch für die diesbezüglichen drei Ausgestaltungen der Anordnung.

In der ersten dieser drei Ausgestaltungen sind je ein Tiefpaßfilter und ein Hochpaßfilter zur Aufteilung der Folgesignals in dem Gleichanteil und dem Restanteil vorgesehen. An einem Ausgang des Tiefpaßfilters steht der Gleichanteil an, und an einem Ausgang des Hochpaßfilters steht der Restanteil an. Vorteilhaft ist, daß Hochpaßfilter gerade komplementär zum Tiefpaßfilter ausgebildet sind.

In der zweiten Ausgestaltung ist ebenfalls ein Tiefpaßfilter zur Bildung des Gleichanteils vorgesehen. An einem positiven Eingang eines Summenglieds steht das Folgesignal an, an einem negativen Eingang des Summenglieds steht der Gleichanteil an, so daß das Summenglied den Restanteil als Differenz aus dem Folgesignal und dem Gleichanteil bildet.

In der dritten Ausgestaltung ist eine einstellbare Offset-Quelle vorgesehen. Ein Ausgangssignal der Offset-Quelle stellt in dieser Ausgestaltung den Gleichanteil des Folgesignals dar. Analog zur beschriebenen zweiten Ausgestaltung liefert ein Summenglied den Restanteil als Differenz aus dem Folgesignal und dem hier durch das Ausgangssignal der Offset-Quelle gebildeten Gleichanteil.

Ein Vorteil der letztgenannten Ausgestaltung besteht in der Einsparung des A/D-Wandlers zur Bestimmung des digitalen Gleichanteils. Da das Ausgangssignal der Offset-Quelle bekannt und fest vorgegeben ist, kann es in der digitalen Berechnungseinheit direkt als digitaler Gleichanteil gespeichert werden.

Eine weitere vorteilhafte Ausführungsform der Anordnung hat die Bildung des Folgesignals zum Gegenstand. Es ist ein Summenglied vorgesehen, von dem ein positiver Eingang mit dem einen der beiden elektrischen Signal und von dem ein negativer Eingang mit dem anderen der beiden elektrischen Signal belegt sind. Das Summenglied liefert das Folgesignal als Differenzsignal aus den beiden elektrischen Signalen. Der durch Störgrößen bestimmte Gleichanteil dieses Differenzsignals kann somit durch die Abspaltung vor dem analogen Verstärker in seinem Einfluß minimiert werden. Am analogen Verstärker steht nur der Restanteil an, der die Meßinformation trägt. Der störgrößenbehaftete Gleichanteil wird nicht verstärkt.

Die Digitalisierungsmittel zur Erzeugung von digitalen elektrischen Signalen, eines digitalen Gleichanteils und eines digitalen verstärkten Restanteils sind in einer bevorzugten Variante der Anordnung jeweils als A/D-Wandler ausgebildet.

In einer vorteilhaften Abwandlung dieser Variante kann der A/D-Wandler zur Digitalisierung des Gleichanteils entfallen. Der für die Berechnung des digitalen Polarisationssignals in der digitalen Berechnungseinheit benötigte digitale Gleichanteil kann bereits in der digitalen Berechnungseinheit in gespeicherter Form vorliegen. Hierzu wird auf die Ausführungen zur Aufteilung des Folgesignals in Gleichanteil und Restanteil mittels einer Offset-Quelle verwiesen.

Andererseits ist es jedoch auch möglich, den digitalen Gleichanteil in der digitalen Berechnungseinheit durch eine digitale Filterung der digitalen elektrischen Signale zu ermitteln. Die digitalen elektrischen Signale stehen der digitalen Berechnungseinheit ohnehin zur Verfügung. Die digitale Filterung in der digitalen Berechnungseinheit bildet dann genau die Charakteristik des zur Aufteilung in Gleichanteil und Restanteil verwendeten Tiefpaßfilters nach.

Vorteilhaft enthält die digitale Berechnungseinheit als Rechenwerk einen digitalen Signalprozessor (DSP), einen Mikrocontroller, einen Mikroprozessor oder einen ASIC (Application Specific Integrated Circuit). Diese Rechenwerke sind für die genannten, in Echtzeit durchzuführenden Berechnungen, wie die digitale Filterung, die Kompensation von Temperatureinflüssen oder die Kennlinienlinearisierung, aufgrund ihrer hohen Bearbeitungsgeschwindigkeit und ihrer hohen arithmetischen Genauigkeit besonders geeignet.

In einer anderen bevorzugten Ausführungsform der Anordnung ist der optische Wandler für die elektrische Wechselgröße mit einer zweikanaligen Auswertung ausgestattet, die eine Reihenschaltung des Sensorelements, eines strahlteilenden Analysators, bevorzugt in Gestalt eines Wollaston-Prismas oder eines polarisierenden Strahlteilers, sowie der beiden photoelektrischen Wandlereinheiten umfaßt. In dem Analysator wird ein Lichtsignal, das zuvor das Sensorelement passiert hat, in zwei Lichtteilsignale mit zueinander senkrechten Polarisationsebenen aufgeteilt. Die photoelektrischen Wandlereinheiten setzen die beiden Lichtteilsignale in die beiden elektrischen Signale um. Die photoelektrischen Wandlereinheiten sind bevorzugt jeweils aus einer Photodiode und einem nachgeschalteten Transimpedanz-Verstärker aufgebaut. Bevorzugt sind die elektrischen Signale dabei proportional zu den Lichtintensitäten der beiden Lichtteilsignale.

Eine bevorzugte Variante der beschriebenen Ausführungsform mit zweikanaliger Auswertung sieht das Sensorelement als ein magnetfeldempfindliches Faraday-Element oder als ein auf ein elektrisches Feld empfindliches Pockels-Element vor.

Das magnetfeldempfindliche Faraday-Element kann dabei in Form eines Glasrings oder einer Faserspule vorliegen, durch die jeweils ein stromdurchflossener elektrischer Leiter hindurchgeführt ist. Ein im elektrischen Leiter fließender Wechselstrom stellt dann die zu detektierende Wechselgröße dar. Das Faraday-Element ist sensitiv für ein vom Strom erzeugtes Magnetfeld.

Das Pockels-Element kann in Form eines elektrooptischen Einkristalls vorliegen, der das Lichtsignal beim Passieren in seiner Polarisation ändert. Die Änderung ist abhängig von einem elektrischen Feld, in dem sich der elektrooptische Einkristall befindet. Das elektrische Feld im elektrooptischen Einkristall kann aber auch über eine elektrische Wechselspannung, die an elektrischen Zuführungen am elektrooptischen Einkristall ansteht, erzeugt werden. Diese elektrische Wechselspannung stellt dann die zu detektierende Wechselgröße dar.

In einer weiteren bevorzugten Ausführungsform der Anordnung ist der optische Wandler für die elektrische Wechselgröße mit einer gegenläufigen Einspeisung eines ersten und eines zweiten Lichtsignals ausgestattet. Dazu sind Mittel vorgesehen, die die beiden Lichtsignale mit jeweils gegenläufiger Laufrichtung in ein magnetfeldempfindliches Faraday-Element einspeisen und nach dem Durchlaufen des Faraday-Elements jeweils einer der beiden photoelektrischen Wandlereinheiten zuführen. Diese Mittel sind bevorzugt als Koppler, insbesondere als Faserkoppler, ausgebildet.

Bevorzugte Ausführungsbeispiele werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen

| Figur 1 | eine Anordnung zur Verarbeitung eines analogen Signals, |
|---|---|
| Figur 2 | einen optischen Stromwandler mit einer Verarbeitung nach dem Stand der Technik, |
| Figur 3 | Anordnungen zur Verarbeitung von zwei Ausgangsgrößen eines optischen Wandlers, |
| Figuren 4 bis 6 | Digitalisierungseinheiten mit Vorrichtungen zur Aufteilung des Folgesignals, zur Verstärkung des Restanteils und zur Digitalisierung, |
| Figuren 7 und 8 | weitere Anordnungen zur Verarbeitung von zwei Ausgangsgrößen eines optischen Wandlers, |
| Figur 9 | einen optischen Stromwandler mit zweikanaliger Auswertung, |
| Figur 10 | einen optischen Spannungswandler mit zweikanaliger Auswertung und |
| Figur 11 | einen optischen Stromwandler mit gegenläufiger Lichteinspeisung. |

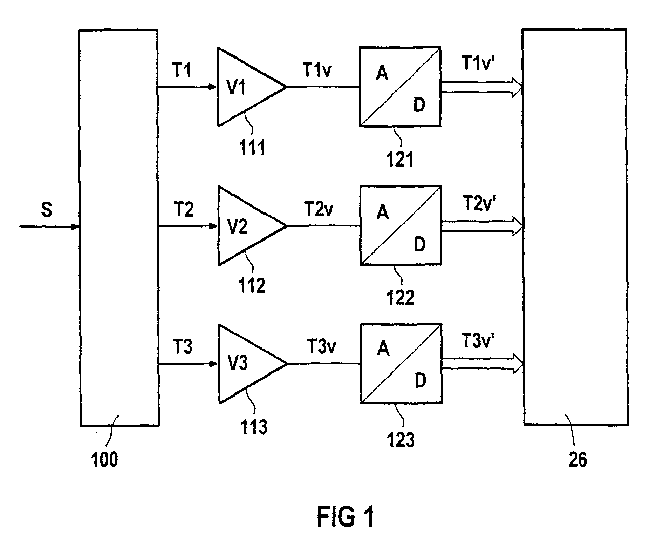

Einander entsprechende Teile sind in den Figuren 1 bis 11 mit denselben Bezugszeichen versehen.

In Figur 1 ist eine Anordnung zur Verarbeitung eines analogen Signals S dargestellt. Das analoge Signal stellt im vorliegenden Fall eine Ausgangsgröße eines optischen Wandlers für eine elektrische Meßgröße dar. Die Ausgangsgröße eines derartigen optischen Wandlers, der im Bereich der öffentlichen elektrischen Energieversorgung eingesetzt wird, überstreicht einen Frequenzbereich von 0 Hz bis zu einigen 10 kHz. Dabei liegen einzelne Frequenzanteile mit jeweils stark voneinander abweichenden Signalpegeln vor. Von Interesse sind dabei insbesondere ein Gleichanteil, ein Frequenzanteil bei der 50 Hz/60 Hz-Netzfrequenz sowie Oberwellen dieser Netzfrequenz. Außerdem weisen transiente Vorgänge einen Frequenzanteil auf, der bis zu einigen 10 kHz von Interesse ist.

Um ein möglichst gutes Gesamt-S/N-Verhältnis zu erhalten, teilt ein analoges Frequenzfilter 100 das analoge Signal S entsprechend der hauptsächlich interessierenden Frequenzbereiche in drei Teilsignale T1, T2 und T3 auf. Das erste Teilsignal T1 entspricht dabei einem Gleichanteil, das zweite Teilsignal T2 einem Netzfrequenzanteil und das dritte Teilsignal T3 einem Frequenzanteil, der höhere Frequenzen als die Netzfrequenz umfaßt.

Die drei Teilsignale T1, T2 und T3 werden in analogen Verstärkern 111, 112, 113 mit jeweils zugehörigen analogen Skalierungsfaktoren V1, V2 und V3 verstärkt. Die analogen Skalierungsfaktoren V1, V2 und V3 sind jeweils so bemessen, daß am Ausgang der Verstärker 111, 112 und 113 jeweils verstärkte Teilsignale T1v, T2v und T3v anstehen, die nachgeschaltete Analog-Digital (A/D)-Wandlern 121, 122 und 123 optimal aussteuern. Die analoge Verstärkung paßt die Teilsignale T1, T2 und T3 in ihren Pegeln jeweils an die Aussteuerbereiche der A/D-Wandler 121, 122 und 123 an.

Die A/D-Wandler 121, 122 und 123 erzeugen digitale Teilsignale T1v', T2v' und T3v' mit einem verbesserten S/N-Verhältnis, da durch die vorgeschaltete Pegelanpassung in den Verstärkern 111, 112 und 113 Nutzsignalanteile in den Teilsignalen T1, T2 und T3 angehoben werden und gleichzeitig ein Quantisierungsrauschen der A/D-Wandler 121, 122 und 123 konstant bleibt.

Die digitalen Teilsignale T1v', T2v' und T3v' werden in eine digitale Berechnungseinheit 26 eingespeist, in der sich weitere digitale Verarbeitungsmaßnahmen anschließen. Beispielsweise kann ein digitales Nachbild des analogen Signals S erzeugt werden, indem die digitalen Teilsignale T1v', T2v' und T3v' einer digitalen Division unterzogen werden, die einer Inversoperation der analogen Verstärkung entspricht. Nach einer Summation der dann vorliegenden Signale ergibt sich das digitale Abbild des analogen Signals S. Gegebenenfalls kann auch noch eine digitale Filterung zwischengeschaltet werden, um bei der Frequenzaufteilung des analogen Signals S in die Teilsignale T1, T2 und T3 entstandene Phasen- und/oder Amplitudenfehler zu korrigieren. Außerdem wird in der digitalen Berechnungseinheit 26 anhand der digitalen Teilsignale T1v', T2v' und T3v' ein Meßsignal für die elektrische Meßgröße des optischen Wandlers ermittelt.

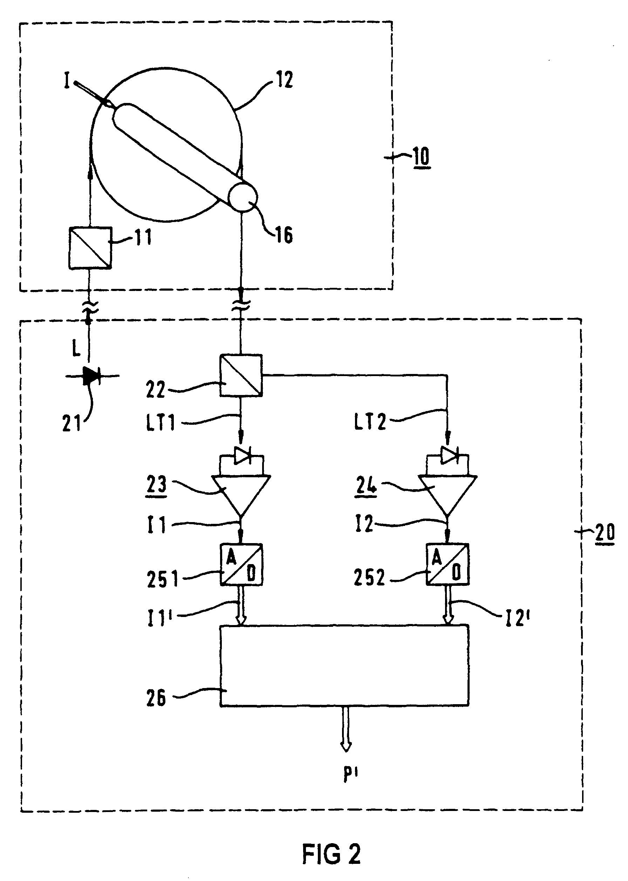

Zur Verdeutlichung der Unterschiede zeigt Figur 2 einen optischen Stromwandler mit einer Verarbeitung von analogen Signalen nach dem Stand der Technik.

Der Stromwandler ist in eine Sensoreinheit 10 und eine Sende-/Empfangseinheit 20 unterteilt. Die Sensoreinheit 10 enthält ein Sensorelement, im vorliegenden Fall ein Faraday-Element 12, das einen von einem elektrischen Strom I durchflossenen elektrischen Leiter 16 umschließt, und befindet sich in lokaler Entfernung zu der Sende-/Empfangseinheit 20. Bei Anwendungen im Bereich der elektrischen Energieversorgung befindet sich die Sensoreinheit 10 zusätzlich auf Hochspannungspotential, wohingegen die Sende-/Empfangseinheit 20 auf Erdpotential stationiert ist.

In einer Lichtquelle 21 der Sende-/Empfangseinheit 20 wird ein Lichtsignal L erzeugt und zur Sensoreinheit 10 gesendet. Vor Durchlaufen des Faraday-Elements 12 wird das Lichtsignal L in einem Polarisator 11 linear polarisiert. Dieser Polarisator 11 kann sich auf Erd- oder auf Hochspannungspotential befinden. In der dargestellten Anordnung ist der Polarisator 11 der Sensoreinheit 10 zugeordnet. Das Lichtsignal L durchläuft das Faraday-Element 12, wobei seine Polarisation in Abhängigkeit des zu messenden Stroms I verändert wird, und läuft dann zur Sende-/Empfangseinheit 20 zurück.

Dort wird es in einem Polarisator 22 in zwei Lichtteilsignale LT1 und LT2 zerlegt (zweikanalige Auswertung), die zueinander senkrechte Polarisationenebenen aufweisen. Beide Lichtteilsignale LT1 und LT2 werden in photoelektrischen Wandlereinheiten 23 und 24 in elektrische Signale I1 und I2 umgewandelt. Die elektrischen Signale I1 und I2 sind Intensitäten der Lichtteilsignale LT1 und LT2 proportional. Sie entsprechen dem analogen Signal S von Figur 1. Die photoelektrischen Wandlereinheiten 23 und 24 bestehen jeweils aus einer Photodiode und einem nachgeschalteten Transimpedanz-Verstärker.

Zur Verarbeitung werden die elektrischen Signale I1 und I2 zunächst jeweils in einem A/D-Wandler 251 bzw. 252 digitalisiert. Dann vorliegende digitale elektrische Signale I1' und I2' sind Eingangsgrößen für eine digitale Berechnungseinheit 26, in der ein digitales Polarisationssignal P' ermittelt wird. Das digitale Polarisationssignal P' ist ein Maß für eine vom zu messenden Strom I verursachte Polarisationsänderung im Lichtsignal L und folglich auch ein Maß für den Strom I selbst. Beim Stand der Technik wird das Polarisationssignal P' entsprechend der Formel gemäß Gleichung (1) aus den digitalen elektrischen Signalen I1' und I2' bestimmt:

$$P' = \frac{(I1'-I2')}{(I1'+I2')} \qquad\qquad (4)$$

Dies führt u.a. auch aufgrund von Quantisierungsrauschen der A/D-Wandler 251 und 252 zu Problemen bei der Detektierbarkeit insbesondere kleiner Signalamplituden des elektrischen Stroms I.

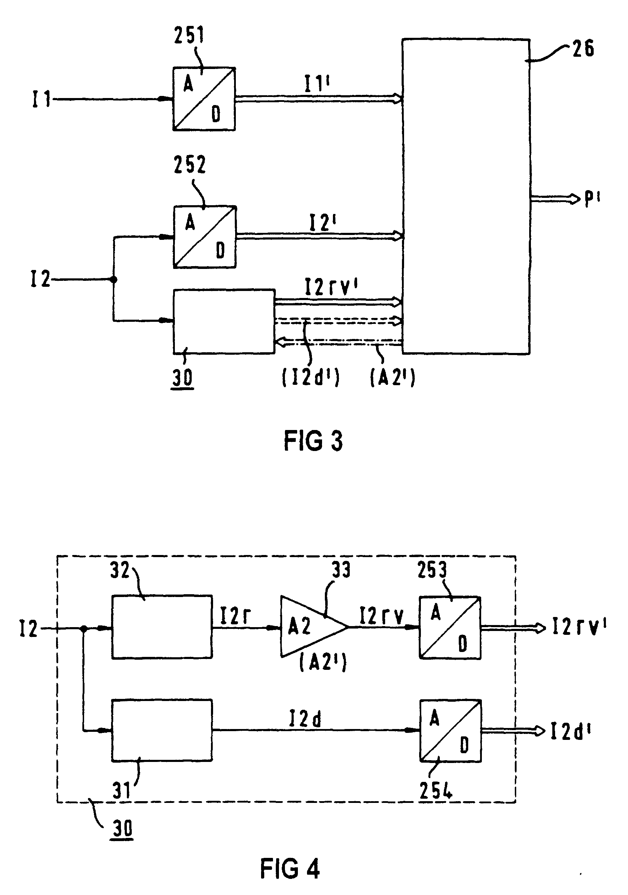

In der Figur 3 ist eine Anordnung zur Verarbeitung von zwei Ausgangsgrößen eines optischen Wandlers dargestellt, bei der das bestimmte digitale Polarisationssignal P' ein verbessertes S/N-Verhältnis im Vergleich zum Stand der Technik nach Figur 2 aufweist. Insbesondere wird der Einfluß des Rauschbeitrags, der durch die Quantisierung der elektrischen Signale I1 und I2 zwangsläufig in den A/D-Wandlern 251 und 252 entsteht, auf das resultierende S/N Verhältnis reduziert.

Der digitalen Berechnungseinheit 26 wird dazu neben den digitalen elektrischen Signalen I1' und I2' von einer zusätzlichen Digitaliserungseinheit 30 mindestens ein weiteres digitales Signal für die Berechnung des digitalen Polarisationssignals P' zur Verfügung gestellt. Zur Durchführung der Berechnung umfaßt die digitale Berechnungseinheit 26 im vorliegenden Fall einen digitalen Signalprozessor.

Hinsichtlich des Rauschens erweist sich die Differenz der digitalen elektrischen Signale I1' und I2' im Zähler des Quotienten der Gleichung (4) als kritische Größe. Die Gleichung (4) kann äquivalent in:

$$P' = 1 - 2 \cdot \frac{I2'}{(I1'+I2')} \qquad\qquad (5)$$

umgeformt werden. Der Nenner im Quotienten von Gleichung (5) enthält eine für das Rauschen als unkritisch anzusehende Summe der digitalen elektrischen Signale I1' und I2'. Sie kann somit genau wie im Stand der Technik gebildet werden.

Für eine Verbesserung des resultierenden gesamten S/N-Verhältnisses verbleibt somit nur eine Optimierung des digitalen elektrischen Signals I2' im Zähler des Quotienten von Gleichung (5).

Die elektrischen Signale I1 und I2 setzen sich bei kleinen Signalamplituden der zu messenden elektrischen Wechselgröße jeweils aus einem dominanten Gleichanteil I1d und I2d sowie einem sehr viel kleineren Restanteil I1r und I2r zusammen.

Nachfolgend werden die Zusammenhänge nur anhand des elektrischen Signals I2 erläutert. Sie gelten jedoch analog auch für das elektrische Signal I1.

Nur der Restanteil I2r, nicht jedoch der Gleichanteil I2d trägt die Information über die zu messende elektrische Wechselgröße. Eine Verstärkung des elektrischen Signals I2 als Ganzes zur Anpassung an den Aussteuerbereich des A/D-Wandlers 252 würde stets durch den dominanten Gleichanteil I2d limitiert. Bei einer gesonderten analogen Verstärkung nur des Restanteils I2r kann dagegen ein wesentlich höherer analoger Verstärkungsfaktor A2 vorgesehen werden, ohne einen nachgeschalteten A/D-Wandler zu übersteuern. Gleichzeitig bleibt das Quantisierungsrauschen des nachgeschalteten A/D-Wandlers absolut gesehen konstant. Relativ zum verstärkten Nutzsignal (= verstärkter Restanteil I2rv) hat sich dann aber der Beitrag des Quantisierungsrauschen bei einem nach der Digitalisierung vorliegenden digitalen verstärkten Restanteil I2rv' verringert.

In der digitalen Berechnungseinheit 26 wird das digitale elektrische Signal I2' unter anderem aus dem digitalen verstärkten Restanteil I2rv' synthetisch zusammengesetzt gemäß:

$$I2' = \frac{I2rv'}{A2'} + I2d' \, , \qquad\qquad (6)$$

wobei mit I2d' ein digitaler Gleichanteil und mit A2' ein digitaler Verstärkungsfaktor bezeichnet sind, die beide als feste digitale Werte in der digitalen Berechnungseinheit 26 in gespeicherter Form vorliegen.

In einer alternativen Ausführungsform kann der digitale Restanteil I2d' auch von der Digitalisierungseinheit 30 zur Verfügung gestellt werden. Dieser Fall ist in Figur 3 durch gestrichelte Linien und die Einklammerung dargestellt.

Der digitale Verstärkungsfaktor A2' entspricht dem digitalen Wert des bei der Verstärkung des Restanteils I2r verwendeten analogen Verstärkungsfaktors A2.

In einer weiteren alternativen Ausführungsform liegt der digitale Verstärkungsfaktor A2' nicht als fest gespeicherter digitaler Wert vor, vielmehr wird er in der digitalen Berechnungseinheit 26 je nach aktueller Aussteuerung des dem digitalen verstärkten Restanteil I2rv' zugeordneten A/D-Wandlers neu bestimmt. Der jeweils aktuelle digitale Verstärkungsfaktor A2' wird dann der Digitalisierungseinheit 30 zur entsprechenden Anpassung des analogen Verstärkungsfaktors A2 zur Verfügung gestellt. Diese Anpassung wird dabei mit Hilfe eines digital programmierbaren Analogverstärkers durchgeführt. In Figur 3 ist diese Ausführungsform durch strichpunktierte Linien und die Einklammerung dargestellt.

Mit Hilfe des gemäß Gleichung (6) synthetisierten digitalen elektrischen Signals I2' und Gleichung (5) wird das digitale Polarisationssignal P' gemäß:

$$P' = 1 - 2 \cdot \frac{\frac{I2rv'}{A2'} + I2d'}{(I1'+I2')} \qquad\qquad (7)$$

in der digitalen Berechnungseinheit 26 bestimmt und auf einen Ausgang gegeben. Im Vergleich zu einem gemäß dem Stand der Technik entsprechend Gleichung (4) bestimmten digitalen Polarisationssignal P' weist ein gemäß Gleichung (7) bestimmtes digitales Polarisationssignal P' im S/N-Verhältnis einen Gewinn von bis zu 6 dB multipliziert mit dem Logarithmus Dualis des analogen Verstärkungsfaktors A2 auf.

In den Figuren 4 bis 6 werden nachfolgend Realisierungsbeispiele für die Digitalisierungseinheit 30 dargestellt.

Eingangsgröße der Digitalisierungseinheit 30 in den Figuren 4 bis 6 ist jeweils ein Folgesignal, das aus den elektrischen Signalen I1 und I2 abgeleitet wird. Im einfachsten Fall ist das Folgesignal identisch mit einem der beiden elektrischen Signale I1 und I2. Ohne Einschränkung der Allgemeingültigkeit ist in den Figuren 4 bis 6 jeweils der Fall zugrunde gelegt, in dem das Folgesignal gerade dem elektrischen Signal I2 entspricht.

In dem in Figur 4 gezeigten ersten Realisierungsbeispiel der Digitalisierungseinheit 30 wird das elektrische Signal I2 einem Tiefpaßfilter 31 und einem Hochpaßfilter 32 zugeführt. Das Tiefpaßfilter 31 und das Hochpaßfilter 32 liefern eine Aufteilung des elektrischen Signals I2 in einen Gleichanteil I2d, der an einem Ausgang des Tiefpaßfilters 31 ansteht, und in einen Restanteil I2r, der am Ausgang des Hochpaßfilters 32 ansteht. Der Gleichanteil I2d wird unmittelbar über einen A/D-Wandler 254 in einen korrespondierenden digitalen Gleichanteil I2d' umgesetzt. Der Restanteil I2r wird vor der Digitalisierung zunächst mittels eines analogen Verstärkers 33 um den analogen Verstärkungsfaktor A2 verstärkt. Ein an einem Ausgang des analogen Verstärkers 33 anstehender verstärkter Restanteil I2rv wird einem A/D-Wandler 253 zur Erzeugung des digitalen verstärkten Restanteils I2rv' zugeführt.

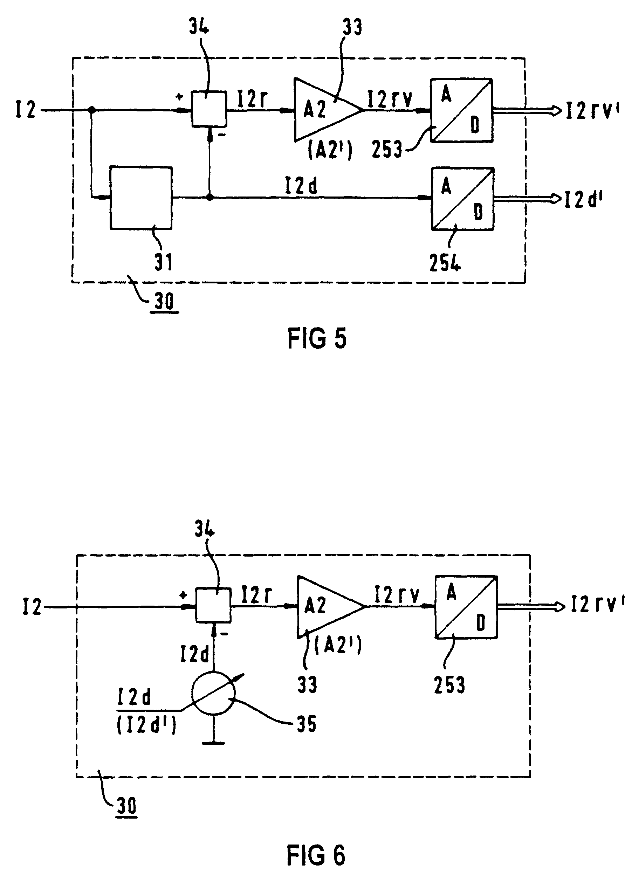

Bei der in Figur 5 dargestellten Digitalisierungseinheit 30 ist das Hochpaßfilter 32 der Anordnung von Figur 4 durch ein Summenglied 34 ersetzt worden. Dabei steht an einem positiven Eingang des Summenglieds 34 das elektrische Signal I2 und an einem negativen Eingang des Summenglieds 34 der vom Tiefpaßfilter 31 erzeugte Gleichanteil I2d an. Auf diese Weise liefert das Summenglied 34 den Restanteil I2r als Differenz aus dem elektrischen Signal I2 und dem Gleichanteil I2d.

Bei der in Figur 6 dargestellten Digitalisierungseinheit 30 ist zusätzlich auch das Tiefpaßfilter 31 der Figuren 4 und 5 durch eine Offset-Quelle 35 ersetzt worden. Der Gleichanteil I2d des elektrischen Signals I2 ist seinem Wert nach im wesentlichen bekannt. Dies ergibt sich aus der Kenntnis der Lichtintensität des Lichtsignals L, das in die Sensoreinheit 10 eingestrahlt wird, aus einem Teilungsverhältnis des Analysators 22 sowie aus einer Konvertierungskonstanten der photoelektrischen Wandlereinheit 24. Stellt man die Offset-Quelle 35 genau auf diesen bekannten Wert des Gleichanteils I2d ein, so kann mit Hilfe des von der Offset-Quelle 35 gelieferten, nachgebildeten Gleichanteils I2d der Restanteil I2r nach dem bei Figur 5 beschriebenen Verfahren als Differenz aus dem elektrischen Signal I2 und dem Gleichanteil I2d ermittelt werden.

In den Figuren 4 bis 6 sind Bezugszeichen für einen digitalen Verstärkungsfaktor A2' sowie für den digitalen Gleichanteil I2d' (nur in Figur 6) eingeklammert. Diese Darstellungsform soll andeuten, daß die besagten Größen der digitalen Berechnungseinheit 26 als feste Parameter zur Verfügung gestellt und dort gespeichert werden. Alternativ dazu kann der digitale Verstärkungsfaktor A2' aber entsprechend den obigen Ausführungen auch als variabler, von der digitalen Berechnungseinheit 26 ermittelter Wert zur Anpassung des analogen Verstärkungsfaktors A2 zur Verfügung gestellt werden. Der analoge Verstärker 33 ist dann als digital programmierbarer Analogverstärker ausgebildet.

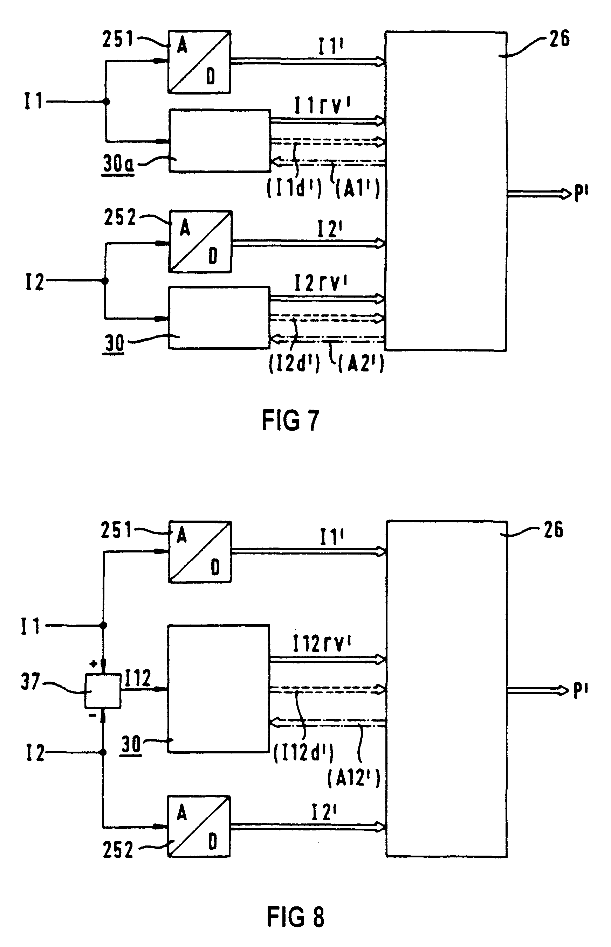

Die Figuren 7 und 8 zeigen weitere Realisierungsbeispiele für Anordnungen zur Verarbeitung von zwei Ausgangsgrößen eines optischen Wandlers, die ein gegenüber dem Stand der Technik nach Figur 2 verbessertes S/N Verhältnis aufweisen.

In dem Realisierungsbeispiel von Figur 7 wird im Unterschied zu Figur 3 auch für das elektrische Signal I1 in einer zusätzlichen Digitalisierungseinheit 30a ein digitaler verstärkter Restanteil I1rv' erzeugt und der digitalen Berechnungseinheit 26 zur Verfügung gestellt. Diese erzeugt entsprechend Gleichung (6) auch für das digitale elektrische Signal I1' ein synthetisches Pendant und führt damit die Berechnung des digitalen Polarisationssignals P' gemäß:

$$P' = \frac{\left(\dfrac{I1rv'}{A1'} + I1d'\right) - \left(\dfrac{I2rv'}{A2'} + I2d'\right)}{(I1' + I2')} \tag{8}$$

aus, wobei mit I1d' ein digitaler Gleichanteil und mit A1' ein digitaler Verstärkungsfaktor bezeichnet sind, die beide genau wie der digitale Gleichanteil I2d' und der digitale Verstärkungsfaktor A2' als feste digitale Werte in der digitalen Berechnungseinheit 26 in gespeicherter Form vorliegen.

Im Realisierungsbeispiel von Figur 8 wird zunächst aus den elektrischen Signalen I1 und I2 ein Differenzsignal I12 mittels eines Summenglieds 37 gebildet. Das Differenzsignal I12 entspricht somit dem Zähler des Quotienten in Gleichung (1). Die Digitalisierungseinheit 30 bestimmt aus dem Differenzsignal I12 einen digitalen verstärkten Restanteil I12rv', der wie die digitalen elektrischen Signalen I1' und I2' der digitalen Berechnungseinheit 26 als Eingangsgröße zur Verfügung gestellt wird. Damit ermittelt die digitale Berechnungseinheit 26 das digitale Polarisationssignal P' nach folgender Vorschrift:

$$P' = \frac{\dfrac{I12rv'}{A12'} + I12d'}{(I1'+I2')} \ , \tag{9}$$

wobei mit I12d' ein digitaler Gleichanteil und mit A12' ein digitaler Verstärkungsfaktor bezeichnet sind, die beide als feste digitale Werte in der digitalen Berechnungseinheit 26 in gespeicherter Form vorliegen.

Die im Zusammenhang mit Figur 3 gemachten Ausführungen in bezug auf die gestrichelten und strichpunktierten Linien, die Einklammerungen von A2' und von I2d' sowie auf die Herkunft des digitalen Verstärkungsfaktors A2' sind analog auf die Ausführungsbeispiele der Figuren 7 und 8 zu übertragen. Dies gilt insbesondere auch für die digitalen Gleichanteile I1d' und I12d' sowie für die digitalen Verstärkungsfaktoren A1' und A12'.

Da der digitalen Berechnungseinheit 26 in allen Realisierungsbeispielen von Figur 3, 7 und 8 jeweils auch die digitalen elektrischen Signale I1' und I2' zur Verfügung stehen, kann auch ein digitales Polarisationssignal P' gemäß Gleichung (4) ermittelt werden.

Stehen nun große Signalamplituden der zu messenden elektrischen Wechselgröße an, so daß die Gleichanteile I1d und I2d der elektrischen Signale I1 und I2 nicht mehr groß gegenüber den informationstragenden Restanteilen I2r und I1r sind, so führt die digitale Berechnungseinheit 26 die Berechnung des Polarisationssignals P' tatsächlich gemäß der Gleichung (4) durch. Die vorteilhafte Wirkung einer Verstärkung der Restanteile I1r und I2r ist in diesem Fall nämlich nicht mehr gegeben. Die digitale Berechnungseinheit 26 führt also eine Erkennung der aktuellen Signalamplituden der zu messenden elektrischen Wechselgröße durch, und ermittelt das digitale Polarisationssignal P' dann entsprechend diesen aktuellen Signalamplituden. Bei großen Signalamplituden geschieht dies gemäß Gleichung (4), bei kleinen Signalamplituden gemäß einer der Gleichungen (7) bis (9).

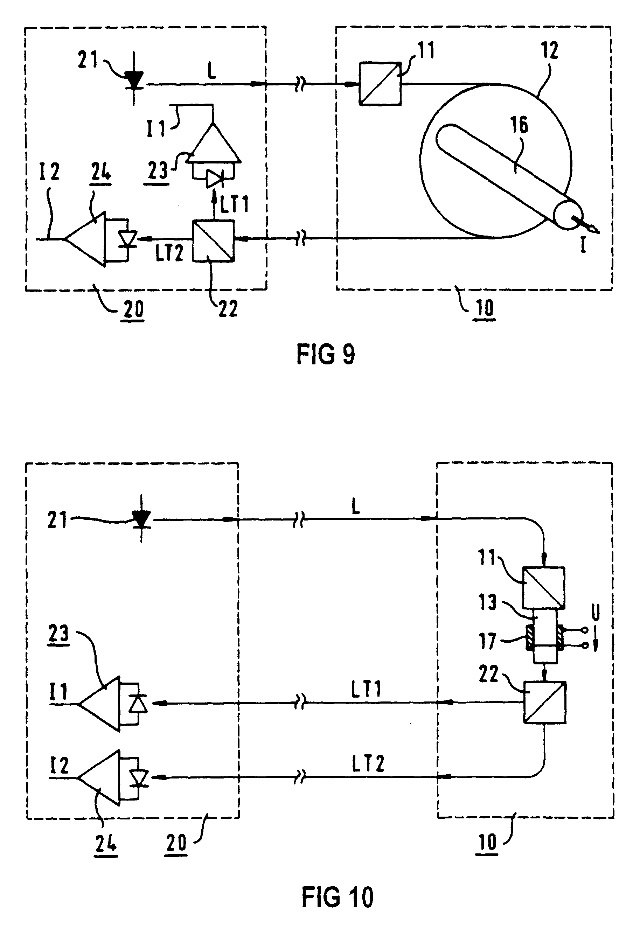

Die Figuren 9 bis 11 zeigen optische Wandler für elektrische Wechselgrößen mit zwei Ausgangssignalen in Form der elektrischen Signale I1 und I2. Somit können diese optischen Wandler mit den in den Figuren 3 bis 8 dargestellten Anordnungen zur Verarbeitung betrieben werden.

Bei dem optischen Wandler von Figur 9 handelt es sich um eine Ausführungsform, die bereits im Zusammenhang mit dem Stand der Technik gemäß Figur 2 beschrieben worden ist.

In Figur 10 wird ein optischer Wandler zur Erfassung einer elektrischen Spannung U dargestellt. Im Unterschied zu dem Stromwandler von Figur 9 bzw. Figur 2 enthält die Sensoreinheit 10 in diesem Fall anstelle des Faraday-Elements 12 ein Pockels-Element 13, an das die zu messende elektrische Spannung mittels elektrischen Zuführungen 17 angelegt wird. Analog zum elektrischen Strom I bei den Anordnungen von Figur 2 und 9 erzeugt bei dem optischen Spannungswandler von Figur 10 die elektrische Spannung U eine Änderung der Polarisation des Lichtsignals L. Somit ist die Vorgehensweise bei der Auswertung entsprechend der, die bereits für den optischen Stromwandler beschrieben wurde.

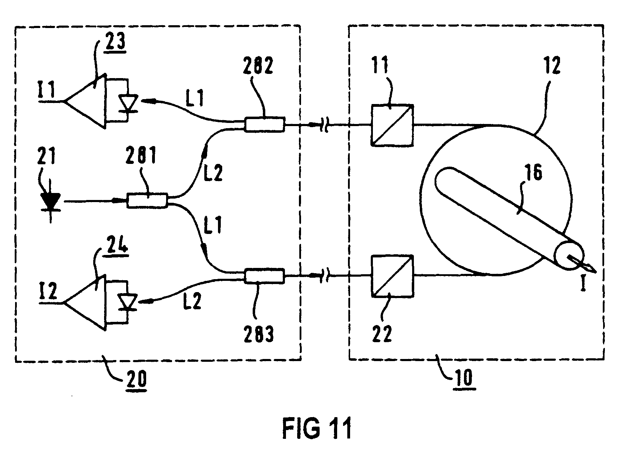

In der Figur 11 wird ein optischer Stromwandler mit gegenläufiger Lichteinspeisung gezeigt. Es sind Koppler, insbesondere Faserkoppler, 281, 282 und 283 vorgesehen, die dafür sorgen, daß zwei Lichtsignale L1 und L2 mit entgegengesetzter Laufrichtung in die Sensoreinheit 10 eingespeist werden, und nach Durchlaufen der Sensoreinheit 10 jeweils einer der beiden photoelektrischen Wandlereinheiten 23 und 24 zugeführt werden. Dort werden die Lichtsignale L1 und L2 in die entsprechenden elektrischen Signale I1 und I2 umgesetzt. Der Analysator 22 führt in dieser Ausführungsform keine Aufteilung in zwei Lichtteilsignale mit zueinander senkrechten Polarisationsebenen durch. Die elektrischen Signale I1 und I2 unterscheiden sich hier durch die unterschiedlichen Laufrichtungen der zugrundeliegenden Lichtsignale L1 und L2.

## Patentansprüche

1. Verfahren zur Verarbeitung mindestens eines analogen, mehrere Frequenzbereiche umfassenden Signals (S), bei dem

    a) das mindestens eine analoge Signal (S) als mindestens ein Folgesignal aus einem ersten und zweiten elektrischen Signal (I1, I2) eines optischen Wandlers für eine elektrische Wechselgröße abgeleitet wird und
    b) von jedem Folgesignal eine Aufteilung in einen Gleichanteil (I2d) und einen Restanteil (I2r) mit voneinander verschiedenem Frequenzbereich vorgenommen wird,
        **dadurch gekennzeichnet, daß**
    c) mittels analoger Verstärkung um einen analogen Verstärkungsfaktor (A2) aus dem Restanteil (I2r) ein verstärkter Restanteil (I2rv) erzeugt wird,
    d) aus den elektrischen Signalen (I1, I2) und dem verstärkten Restanteil (I2rv) digitale elektrische Signale (I1', I2') und ein digitaler verstärkter Restanteil (I1rv', I2rv', I12rv') erzeugt werden, wobei der analoge Verstärkungsfaktor (A2) an einen Aussteuerungsbereich bei der Digitalisierung angepaßt wird, und

e) aus den genannten digitalen Größen sowie aus einem dem Gleichanteil (I2d) entsprechenden digitalen Gleichanteil (I1d', I2d', I12d') und aus einem dem analogen Verstärkungsfaktor (A2) entsprechenden digitalen Verstärkungsfaktor (A2') ein von der zu messenden Wechselgröße abhängiges digitales Polarisationssignal (P') ermittelt wird.

2. Verfahren nach Anspruch 1, **dadurch gekennzeichnet, daß** der Gleichanteil (I2d) durch eine Tiefpaßfilterung und der Restanteil (I2r) durch eine dazu komplementäre Hochpaßfilterung des Folgesignals ermittelt werden.

3. Verfahren nach Anspruch 1, **dadurch gekennzeichnet, daß** der Gleichanteil (I2d) durch eine Tiefpaßfilterung des Folgesignals ermittelt wird, und der Restanteil (I2r) über eine Differenz des Folgesignals und des Gleichanteils (I2d) ermittelt wird.

4. Verfahren nach Anspruch 1, **dadurch gekennzeichnet, daß** als Gleichanteil (I2d) ein vorzugebender Offset-Wert vorgesehen wird, und der Restanteil (I2r) durch eine Differenz des Folgesignals und des Gleichanteils (I2d) ermittelt wird.

5. Verfahren nach einem der Ansprüche 1 bis 4, **dadurch gekennzeichnet, daß** nur ein Folgesignal entsprechend einem der beiden elektrischen Signale (I1, I2) vorgesehen wird, und das digitale Polarisationssignal (P') gemäß der Vorschrift:

$$P' = 1-2*\frac{\frac{I2rv'}{A2'}+I2d'}{I1'+I2'}$$

ermittelt wird, wobei

P' das digitale Polarisationssignal,
I2rv' den digitalen verstärkten Restanteil,
A2' den digitalen Verstärkungsfaktor,
I2d' den digitalen Gleichanteil und
I1', I2' die digitalen elektrischen Signale

darstellen.

6. Verfahren nach einem der Ansprüche 1 bis 4, **dadurch gekennzeichnet, daß** zwei Folgesignale entsprechend jeweils einem der beiden elektrischen Signale (I1, I2) vorgesehen werden, und das digitale Polarisationssignal (P') gemäß der Vorschrift:

$$P' = \frac{\left(\frac{I1rv'}{A1'} + I1d'\right) - \left(\frac{I2rv'}{A2'} + I2d'\right)}{I1'+I2'}$$

ermittelt wird, wobei

P' das digitale Polarisationssignal,
I1rv', I2rv' die digitalen verstärkten Restanteile,
A1', A2' die digitalen Verstärkungsfaktoren,
I1d', I2d' den digitalen Gleichanteil und
I1', I2' die digitalen elektrischen Signale

darstellen.

7. Verfahren nach einem der Ansprüche 1 bis 4, dadurch gekenzeichnet, daß ein Differenzsignal (I12) der beiden elektrischen Signalen (I1, I2) als Folgesignal gebildet wird, und das digitale Polarisationssignal (P') gemäß der

Vorschrift:

$$P' = \frac{\frac{I12rv'}{A12'} + I12d'}{I1' + I2}$$

ermittelt wird, wobei

P'         das digitale Polarisationssignal,
I12rv'    den digitalen verstärkten Restanteil des Differenzsignals,
A12'      den digitalen Verstärkungsfaktor des Differenzsignals,
I12d'     den digitalen Gleichanteil des Differenzsignals und
I1', I2'   die digitalen elektrischen Signale

darstellen.

**8.** Verfahren nach einem der Ansprüche 1 bis 7, **dadurch gekennzeichnet, daß** der digitale Gleichanteil (I1d', I2d', I12d') aus dem Gleichanteil (I2d), insbesondere mittels einer A/D-Wandlung, erzeugt wird oder aus den digitalen elektrischen Signalen (I1', I2') mittels digitaler Filterung bestimmt wird oder als fester digitaler Wert gespeichert wird.

**9.** Verfahren nach einem der Ansprüche 1 bis 8, **dadurch gekennzeichnet, daß** das erste und zweite elektrische Signal (I1, I2) mittels photoelektrischer Wandlung jeweils aus einem ersten und zweiten Lichtteilsignal (LT1, LT2) erzeugt werden, wobei ein Lichtsignal (L) nach Durchlaufen eines Sensorelements in die Lichtteilsignale (LT1, LT2), die senkrecht zueinander polarisiert sind, aufgeteilt wird.

**10.** Verfahren nach Anspruch 9, **dadurch gekennzeichnet, daß** als Sensorelement ein magnetfeldempfindliches Faraday-Element (12) oder ein auf ein elektrisches Feld empfindliches Pockels-Element (13) vorgesehen wird.

**11.** Verfahren nach einem der Ansprüche 1 bis 8, **dadurch gekennzeichnet, daß** das erste und zweite elektrische Signal (I1, I2) mittels photoelektrischer Wandlung jeweils aus einem ersten und zweiten Lichtsignal (L1, L2) erzeugt werden, wobei die beiden Lichtsignale (L1, L2) in entgegengesetzter Richtung durch eine ein magnetfeldempfindliches Faraday-Element (12) umfassende Sensoreinheit (10) gesendet werden.

**12.** Anordnung zur Verarbeitung mindestens eines analogen, mehrere Frequenzbereiche umfassenden Signals (S), umfassend

a) Mittel zur Aufteilung mindestens eines aus zwei elektrischen Signalen (I1, I2) eines optischen Wandlers für eine elektrische Wechselgröße abgeleiteten Folgesignals in einen Gleichanteil (I2d) und einen Restanteil (I2r) mit voneinander verschiedenem Frequenzbereich, wobei das mindestens eine Folgesignal dem mindestens einen analogen Signal (S) entspricht, **gekennzeichnet durch**
b) einen analogen Verstärker (33) mit einem analogen Verstärkungsfaktor (A2) zur Erzeugung eines verstärkten Restanteils (I2rv) aus dem Restanteil (I2r),
c) Digitalisierungsmittel (251, 252, 253) zur Erzeugung von digitalen elektrischen Signalen (I1', I2') und eines digitalen verstärkten Restanteils (I1rv', I2rv', I12rv') jeweils aus den elektrischen Signalen (I1, I2) und dem verstärkten Restanteil (I2rv), wobei der analoge Verstärkungsfaktor (A2) an einen Aussteuerungsbereich der Digitalisierungsmittel (251, 252, 253) angepaßt ist, und
d) eine digitale Berechnungseinheit (26) zur Ermittlung eines von der zu messenden Wechselgröße abhängigen digitalen Polarisationssignals (P') aus den genannten digitalen Größen sowie aus einem dem Gleichanteil (I2d) entsprechenden digitalen Gleichanteil (I1d', I2d', I12d') und aus einem dem analogen Verstärkungsfaktor (A2) entsprechenden digitalen Verstärkungsfaktor (A2').

**13.** Anordnung nach Anspruch 12, **dadurch gekennzeichnet, daß** als Mittel zur Aufteilung jeweils ein Tiefpaßfilter (31), das den Gleichanteil (I2d) des Folgesignals liefert, und ein dazu komplementäres Hochpaßfilter (32), das den Restanteil (I2r) des Folgesignals liefert, vorgesehen sind.

**14.** Anordnung nach Anspruch 12, **dadurch gekennzeichnet, daß** als Mittel zur Aufteilung jeweils ein Tiefpaßfilter (31), das den Gleichanteil (I2d) des Folgesignals liefert, und ein Summenglied (34), das den Restanteil (I2r) des Folgesignals durch Summation des Folgesignals und des invertierten Gleichanteils (I2d) liefert, vorgesehen sind.

**15.** Anordnung nach Anspruch 12, **dadurch gekennzeichnet, daß** als Mittel zur Aufteilung jeweils eine einstellbare Offset-Quelle (35), von der ein Ausgangssignal als Gleichanteil (I2d) des Folgesignals fungiert, und ein Summenglied (34), das den Restanteil (I2r) des Folgesignals durch Summation des Folgesignals und des invertierten Gleichanteils (I2d) liefert, vorgesehen sind.

**16.** Anordnung nach einem der Ansprüche 12 bis 15, **dadurch gekennzeichnet, daß** ein Summenglied (34) zur Bildung des Folgesignals als ein Differenzsignal (I12) der beiden elektrischen Signalen (I1, I2) vorgesehen ist.

**17.** Anordnung nach einem der Ansprüche 12 bis 16, **dadurch gekennzeichnet, daß** Digitalisierungsmittel (254) zur Erzeugung des digitalen Gleichanteils (I1d', I2d', I12d') aus dem Gleichanteil (I2d) vorgesehen sind.

**18.** Anordnung nach einem der Ansprüche 12 bis 17, **dadurch gekennzeichnet, daß** zwei photoelektrischen Wandlereinheiten (23, 24) ein Sensorelement und ein Analysator (22), der ein Lichtsignal (L) nach Durchlaufen des Sensorelements in zwei Lichtteilsignale (LT1, LT2) mit zueinander senkrechter Polarisation aufteilt, vorgeschaltet sind, wobei jeweils eine der beiden photoelektrischen Wandlereinheiten (23, 24) zur Erzeugung jeweils eines der beiden elektrischen Signale (I1, I2) aus jeweils einem der beiden Lichtteilsignale (LT1, LT2) vorgesehen ist.

**19.** Anordnung nach Anspruch 18, **dadurch gekennzeichnet, daß** das Sensorelement als magnetfeldempfindliches Faraday-Element (12) oder als ein auf ein elektrisches Feld empfindliches Pockels-Element (13) ausgebildet ist.

**20.** Anordnung nach einem der Ansprüche 12 bis 17, **dadurch gekennzeichnet, daß** Mittel (281, 282, 283) zur gegenläufigen Einspeisung von einem ersten und zweiten Lichtsignal (L1, L2) in eine ein magnetfeldempfindliches Faraday-Element (12) umfassende Sensoreinheit (10) sowie jeweils eine photoelektrische Wandlereinheit (23, 24) zur Erzeugung jeweils eines der beiden elektrischen Signale (I1, I2) aus jeweils einem der beiden Lichtsignale (L1, L2) vorgesehen sind.

**Claims**

**1.** Method for processing at least one analogue signal (S) comprising a number of frequency ranges, in which

   a) the at least one analogue signal (S) is derived as at least one successor signal from a first and second electrical signal (I1, I2) of an optical transducer for an alternating electrical quantity, and
   b) each successor signal is divided into a DC component (I2d) and a residual component (I2r) having different frequency ranges,
   **characterized in that**
   c) an amplified residual component (I2rv) is generated from the residual component (I2r) by means of analogue amplification by an analogue gain factor (A2),
   d) digital electrical signals (I1', I2') and an amplified digital residual component (I1rv', I2rv', I12rv') are generated from the electrical signals (I1, I2) and the amplified residual component (I2rv), the analogue gain factor (A2) being adapted to a dynamic range during the digitization, and
   e) a digital polarization signal (P'), which depends on the alternating quantity to be measured, is determined from the said digital quantities and from a digital DC component (I1d', I2d', I12d') corresponding to the DC component (I2d) and from a digital gain factor (A2') corresponding to the analogue gain factor (A2).

**2.** Method according to Claim 1, **characterized in that** the DC component (I2d) is determined by low-pass filtering and the residual component (I2r) is determined by complementary high-pass filtering of the successor signal.

**3.** Method according to Claim 1, **characterized in that** the DC component (I2d) is determined by low-pass filtering of the successor signal, and the residual component (I2r) is determined via a difference between the successor signal and the DC component (I2d).

**4.** Method according to Claim 1, **characterized in that** an offset value to be predetermined is provided as DC component (I2d), and the residual component (I2r) is determined by a difference between the successor signal and the DC component (I2d).

5. Method according to one of Claims 1 to 4, **characterized in that** only one successor signal corresponding to one of the two electrical signals (I1, I2) is provided and the digital polarization signal (P') is determined in accordance with the following rule:

$$P' = 1-2*\frac{\frac{I2rv'}{A2'}+I2d'}{I1'+I2'}$$

where

P'        is the digital polarization signal,
I2rv'     is the amplified digital residual component,
A2'       is the digital gain factor,
I2d'      is the digital DC component, and
I1', I2'  are the digital electrical signals.

6. Method according to one of Claims 1 to 4, **characterized in that** two successor signals corresponding in each case to one of the two electrical signals (I1, I2) are provided, and the digital polarization signal (P') is determined in accordance with the following rule:

$$P'=\frac{\left(\frac{I1rv'}{A1'}+I1d'\right)-\left(\frac{I2rv'}{A2'}+I2d'\right)}{I1'+I2'}$$

where

P'              is the digital polarization signal,
I1rv', I2rv'    are the amplified digital residual components,
A1', A2'        are the digital gain factors,
I1d', I2d'      is the digital DC component, and
I1', I2'        are the digital electrical signals.

7. Method according to one of Claims 1 to 4, **characterized in that** a difference signal (I12) of the two electrical signals (I1, I2) is formed as successor signal and the digital polarization signal (P') is determined in accordance with the following rule:

$$P' = \frac{\frac{I12rv'}{A12'}+I12d'}{I1'+I2'}$$

where

P'        is the digital polarization signal,
I12rv'    is the amplified digital residual component of the difference signal,
A12'      is the digital gain factor of the difference signal,
I12d'     is the digital DC component of the difference signal, and
I1', I2'  are the digital electrical signals.

8. Method according to one of Claims 1 to 7, **characterized in that** the digital DC component (I1d', I2d', I12d') is generated from the DC component (I2d), especially by means of an A/D conversion, or is determined from the digital electrical signals (I1', I2') by means of digital filtering or is stored as a fixed digital value.

9. Method according to one of Claims 1 to 8, **characterized in that** the first and second electrical signal (I1, I2) are generated in each case from a first and second partial light signal (LT1, LT2) by means of photo-electric conversion, a light signal (L), after passing through a sensor element, being divided into the partial light signals (LT1, LT2) which are polarized perpendicularly to one another.

**10.** Method according to Claim 9, **characterized in that** a Faraday element (12) sensitive to magnetic fields or a Pockels element (13) sensitive to an electric field is provided as sensor element.

**11.** Method according to one of Claims 1 to 8, **characterized in that** the first and second electrical signal (I1, I2) are in each case generated from a first and second light signal (L1, L2) by means of photo-electric conversion, the two light signals (L1, L2) being sent in opposite directions through a sensor unit (10) comprising a Faraday element (12) which is sensitive to magnetic fields.

**12.** Arrangement for processing at least one analogue signal (S) comprising a number of frequency ranges, comprising

a) means for dividing at least one successor signal, derived from two electrical signals (I1, I2) of an optical transducer for an alternating electrical quantity, into a DC component (I2d) and a residual component (I2r) having different frequency ranges, the at least one successor signal corresponding to the at least one analogue signal (S), **characterized by**

b) an analogue amplifier (33) having an analogue gain factor (A2) for generating an amplified residual component (I2rv) from the residual component (I2r),

c) digitizing means (251, 252, 253) for generating digital electrical signals (I1', I2') and a digital amplified residual component (I1rv', I2rv', I12rv') in each case from the electrical signals (I1, I2) and the amplified residual component (I2rv), the analogue gain factor (A2) being adapted to a dynamic range of the digitizing means (251, 252, 253), and

d) a digital calculating unit (26) for determining a digital polarization signal (P'), which is dependent on the alternating quantity to be measured, from the said digital quantities and from a digital DC component (I1d', I2d', I12d') corresponding to the DC component (I2d) and from a digital gain factor (A2') corresponding to the analogue gain factor (A2).

**13.** Arrangement according to Claim 12, **characterized in that** in each case a low-pass filter (31) which supplies the DC component (I2d) of the successor signal, and a complementary high-pass filter (32) which supplies the residual component (I2r) of the successor signal, are provided as means for dividing.

**14.** Arrangement according to Claim 12, **characterized in that** in each case a low-pass filter (31) which supplies the DC component (I2d) of the successor signal, and a summing element (34) which supplies the residual component (I2r) of the successor signal by summation of the successor signal and the inverted DC component (I2d), are provided as means for dividing.

**15.** Arrangement according to Claim 12, **characterized in that** in each case an adjustable offset source (35), an output signal of which functions as DC component (I2d) of the successor signal, and a summing element (34) which supplies the residual component (I2r) of the successor signal by summation of the successor signal and the inverted DC component (I2d), are provided as means for dividing.

**16.** Arrangement according to one of Claims 12 to 15, **characterized in that** a summing element (34) is provided for forming the successor signal as a difference signal (I12) between the two electrical signals (I1, I2).

**17.** Arrangement according to one of Claims 12 to 16, **characterized in that** digitizing means (254) are provided for generating the digital DC component (I1d', I2d', I12d') from the DC component (I2d).

**18.** Arrangement according to one of Claims 12 to 17, **characterized in that** two photo-electric transducer units (23, 24) are preceded by a sensor element and an analyser (22) which divides a light signal (L) into two partial light signals (LT1, LT2) with mutually perpendicular polarization after it has passed through the sensor element, in each case one of the two photo-electric transducer units (23, 24) being provided for generating in each case one of the two electrical signals (I1, I2) from in each case one of the two partial light signals (LT1, LT2).

**19.** Arrangement according to Claim 18, **characterized in that** the sensor element is constructed as Faraday element (12) sensitive to magnetic fields or as a Pockels element (13) sensitive to an electric field.

**20.** Arrangement according to one of Claims 12 to 17, **characterized in that** means (281, 282, 283) for the oppositely directed injection of a first and second light signal (L1, L2) into a sensor unit (10) comprising a Faraday element (12) sensitive to magnetic fields and in each case a photo-electric transducer unit (23, 24) for generating in each case one of the two electrical signals (I1, I2) from in each case one of the two light signals (L1, L2) are provided.

**Revendications**

1.  Procédé de traitement d'au moins un signal analogique (S) comprenant plusieurs plages de fréquences, dans lequel

    a) on déduit le ou les signaux analogiques (S), comme un ou des signaux de séquence, d'un premier et d'un deuxième signal électrique (I1, I2) d'un convertisseur optique pour une grandeur alternative électrique et
    b) on effectue pour chaque signal de séquence une division en une composante continue (I2d) et une composante restante (I2r) ayant des plages de fréquences différentes l'une de l'autre,
    **caractérisé par le fait que**
    c) au moyen d'une amplification analogique avec un facteur d'amplification analogique (A2), on produit une composante restante amplifiée (I2rv) à partir de la composante restante (I2r),
    d) à partir des signaux électriques (I1, I2) et de la composante restante amplifiée (I2rv), on produit des signaux électriques numériques (I1', I2') et une composante restante amplifiée numérique (I1rv', I2rv', I12rv'), le facteur d'amplification analogique (A2) étant adapté à une plage dynamique lors de la numérisation, et
    e) à partir des grandeurs numériques mentionnées ainsi qu'à partir d'une composante continue numérique (I1d', I2d', I12d') correspondant à la composante continue (I2d) et à partir d'un facteur d'amplification numérique (A2') correspondant au facteur d'amplification analogique (A2), on détermine un signal de polarisation numérique (P') dépendant de la grandeur alternative à mesurer.

2.  Procédé selon la revendication 1, **caractérisé par le fait qu'**on détermine la composante continue (I2d) au moyen d'un filtrage passe-bas du signal de séquence et la composante restante (I2r) au moyen d'un filtrage passe-haut, complémentaire du précédent, du signal de séquence.

3.  Procédé selon la revendication 1, **caractérisé par le fait qu'**on détermine la composante continue (I2d) au moyen d'un filtrage passe-bas du signal de séquence et la composante restante (I2r) au moyen d'une différence entre le signal de séquence et la composante continue (I2d).

4.  Procédé selon la revendication 1, **caractérisé par le fait qu'**on prévoit comme composante continue (I2d) une valeur d'offset à prescrire et qu'on détermine la composante restante (I2r) au moyen d'une différence entre le signal de séquence et la composante continue (I2d).

5.  Procédé selon l'une des revendications 1 à 4, **caractérisé par le fait qu'**on prévoit seulement un signal de séquence correspondant à l'un des deux signaux électriques (I1, I2) et qu'on détermine le signal de polarisation numérique (P') selon la règle :

$$P' = 1 - 2 * \frac{\frac{I2rv'}{A2'} + I2d'}{I1' + I2'}$$

    avec

    P'      le signal de polarisation numérique,
    I2rv'   la composante restante amplifiée numérique,
    A2'     le facteur d'amplification numérique,
    I2d'    la composante continue numérique et
    I1', I2'   les signaux électriques numériques.

6.  Procédé selon l'une des revendications 1 à 4, **caractérisé par le fait qu'**on prévoit deux signaux de séquence correspondant respectivement à l'un des deux signaux électriques (I1, I2) et qu'on détermine le signal de polarisation numérique (P') selon la règle:

$$P' = \frac{\left(\frac{I1rv'}{A1'} + I1d'\right) - \left(\frac{I2rv'}{A2'} + I2d'\right)}{I1' + I2'}$$

avec

P'    le signal de polarisation numérique,
I1rv', I2rv'    les composantes restantes amplifiées numériques,
A1', A2'    les facteurs d'amplification numériques,
I1d', I2d'    les composantes continues numériques et
I1', I2'    les signaux électriques numériques.

7.  Procédé selon l'une des revendications 1 à 4, **caractérisé par le fait qu'**on forme un signal de différence (I12) des deux signaux électriques (I1, I2) comme signal de séquence et qu'on détermine le signal de polarisation numérique (P') selon la règle :

$$P' = \frac{\frac{I12rv'}{A12'}+I12d'}{I1'+I2'}$$

avec

P'    le signal de polarisation numérique,
I12rv'    la composante restante amplifiée numérique du signal de différence,
A12'    le facteur d'amplification numérique du signal de différence,
I12d'    la composante continue numérique du signal de différence et
I1', I2'    les signaux électriques numériques.

8.  Procédé selon l'une des revendications 1 à 7, **caractérisé par le fait que** la composante continue numérique (I1d', I2d', I12d') est produite à partir de la composante continue (I2d), notamment au moyen d'une conversion analogique-numérique ou est déterminée à partir des signaux électriques numériques (I1', I2') au moyen d'un filtrage numérique ou est mémorisée comme valeur numérique fixe.

9.  Procédé selon l'une des revendications 1 à 8, **caractérisé par le fait qu'**on produit le premier et le deuxième signal électrique (I1, I2) au moyen d'une conversion photoélectrique à chaque fois à partir d'un premier et d'un deuxième signal lumineux partiel (LT1, LT2), un signal lumineux (L) étant divisé, après avoir traversé un élément capteur, en signaux lumineux partiels (LT1, LT2) qui sont polarisés perpendiculairement l'un à l'autre.

10.  Procédé selon la revendication 9, **caractérisé par le fait qu'**on prévoit comme élément capteur un élément de Faraday (12) sensible au champ magnétique ou un élément de Pockel (13) sensible au champ électrique.

11.  Procédé selon l'une des revendications 1 à 8, **caractérisé par le fait qu'**on produit le premier et le deuxième signal électrique (I1, I2) au moyen d'une conversion photoélectrique respectivement à partir d'un premier et d'un deuxième signal lumineux (L1, L2), les deux signaux lumineux (L1, L2) étant émis en sens contraire par une unité de capteur (10) comprenant un élément de Faraday (12) sensible au champ magnétique.

12.  Dispositif de traitement d'au moins un signal analogique (S) comprenant plusieurs plages de fréquences, comportant :

a) des moyens pour diviser au moins un signal de séquence déduit de deux signaux électriques (I1, I2) d'un convertisseur optique pour une grandeur alternative électrique en une composante continue (I2d) et une composante restante (I2r) ayant des plages de fréquences différentes l'une de l'autre, le ou les signaux de séquence correspondant au signal analogique ou aux signaux analogiques (S),

**caractérisé par**

b) un amplificateur analogique (33) avec un facteur d'amplification analogique (A2) pour produire une composante restante amplifiée (I2rv) à partir de la composante restante (I2r),

c) des moyens de numérisation (251, 252, 253) pour produire des signaux électriques numériques (I1', I2') et une composante restante amplifiée numérique (I1rv', I2rv', I12rv') à chaque fois à partir des signaux électriques (I1, I2) et de la composante restante amplifiée (I2rv), le facteur d'amplification analogique (A2) étant adapté à une plage dynamique des moyens de numérisation (251, 252, 253), et

d) une unité de calcul numérique (26) pour déterminer un signal de polarisation numérique (P') dépendant d'une grandeur alternative à mesurer à partir des grandeurs numériques mentionnées ainsi qu'à partir d'une composante continue numérique (I1d', I2d', I12d') correspondant à la composante continue (I2d) et à partir d'un facteur d'amplification numérique (A2') correspondant à un facteur d'amplification analogique (A2).

13. Dispositif selon la revendication 12, **caractérisé par le fait que**, comme moyens de division, il est prévu respectivement un filtre passe-bas (31) qui fournit la composante continue (I2d) du signal de séquence et un filtre passe-haut (32), complémentaire du précédent, qui fournit la composante restante (I2r) du signal de séquence.

14. Dispositif selon la revendication 12, **caractérisé par le fait que**, comme moyens de division, il est prévu à chaque fois un filtre passe-bas (31) qui fournit la composante continue (I2d) du signal de séquence et un élément additionneur (34) qui fournit la composante restante (I2r) du signal de séquence en additionnant le signal de séquence et la composante continue (I2d) inversée.

15. Dispositif selon la revendication 12, **caractérisé par le fait que**, comme moyens de division, il est prévu à chaque fois une source d'offset réglable (35) dont un signal de sortie fait office de composante continue (I2d) du signal de séquence et un élément additionneur (34) qui fournit la composante restante (I2r) du signal de séquence en additionnant le signal de séquence et la composante continue (I2d) inversée.

16. Dispositif selon l'une des revendications 12 à 15, **caractérisé par le fait qu'**un élément additionneur (34) est prévu pour former le signal de séquence comme signal de différence (I12) des deux signaux électriques (I1, I2).

17. Dispositif selon l'une des revendications 12 à 16, **caractérisé par le fait que** des moyens de numérisation (254) sont prévus pour produire la composante continue numérique (I1d', I2d', I12d') à partir de la composante continue (I2d).

18. Dispositif selon l'une des revendications 12 à 17, **caractérisé par le fait qu'**il est branché du côté amont de deux unités de conversion photoélectrique (23, 24) un élément capteur et un analyseur (22) qui divise un signal lumineux (L), après sa traversée de l'élément capteur, en deux signaux lumineux partiels (LT1, LT2) qui sont polarisés perpendiculairement l'un à l'autre, à chaque fois l'une des deux unités de conversion photoélectrique (23, 24) étant prévue pour produire l'un des deux signaux électriques (I1, I2) à partir de l'un des deux signaux lumineux partiels (LT1, LT2).

19. Dispositif selon la revendication 18, **caractérisé par le fait que** l'élément capteur est conçu comme un élément de Faraday (12) sensible au champ magnétique ou comme un élément de Pockel (13) sensible au champ électrique.

20. Dispositif selon l'une des revendications 12 à 17, **caractérisé par le fait que** des moyens (281, 282, 283) sont prévus pour introduire en sens contraire un premier et un deuxième signal lumineux (L1, L2) dans une unité de capteur (10) comprenant un élément de Faraday (12) sensible au champ magnétique et à chaque fois dans une unité de conversion photoélectrique (23, 24) pour produire l'un des deux signaux électriques (I1, I2) à partir de l'un des deux signaux lumineux (L1, L2).

FIG 1

FIG 2

FIG 3

FIG 4

FIG 5

FIG 6

FIG 7

FIG 8

EP 1 073 909 B1

FIG 9

FIG 10

FIG 11